# EUROPEAN PATENT APPLICATION

(11) **EP 3 865 995 A1**
(43) Date of publication of application: **18.08.2021**
(21) Application number: 21156995.9
(22) Date of filing: 12.02.2021
(51) Int. Cl.: G06F 3/16, G10L 15/04, G10L 19/005

(54) **METHOD, DEVICE AND SERVER FOR PLAYING AUDIO**

(30) Priority: 13.02.2020 CN 202010091573
(71) Applicant: Beijing Dajia Internet Information Technology Co., Ltd., Beijing 100085 (CN)
(72) Inventor: ZHANG, Qi, Haidian District, Beijing 100085 (CN)
(74) Representative: Vossius & Partner Patentanwälte Rechtsanwälte mbB

(57) **Abstract**

The disclosure provides a method for playing audio, device, terminal, server and storage medium. The method for playing audio applied to the terminal includes: sending (S11), in response to detecting a voice input, a response request to a server; receiving (S12) a response audio clip carrying position information sent by the server, the position information indicating a position of the response audio clip in a response audio corresponding to the response request; synthesizing (S13), based on the position information carried by respective received response audio clips, adjacent response audio clip s into a response audio packet; playing (S14) the synthesized response audio packet, until finishing playing the response audio.

## Description

### TECHNICAL FIELD

The disclosure relates to the field of audio processing technology, and in particular to a method for playing audio, device, terminal, server, and storage medium.

### BACKGROUND

Nowadays, speech recognition technology has been widely used in all aspects, bringing many conveniences to people's daily life, for example, a voice assistant that can be installed on various terminal devices (e.g., mobile phones). A user can use the voice assistant to know outdoor weather conditions in time before going out. For example, when driving, the user can use the voice assistant to know traffic condition ahead in time.

In related technology, after the user initiates a voice request to the server through the terminal, a complete audio file needs to be downloaded from the server and played. The server usually takes a long time to organize and obtain the audio file. Therefore, in the related technology, it takes a long time to obtain a complete audio file, which results in users not being able to make decisions as quickly as possible, thereby greatly reducing the user experience.

### SUMMARY

The disclosure provides a method for playing audio, device, terminal, server, and storage medium, to reduce delay in responding to a user's voice request and optimize use experience.

According to a first aspect of the disclosure, there is provided a method for playing audio applied to a terminal, and the method includes: sending a response request corresponding to a voice input to a server in response to detecting the voice input; receiving a response audio clip carrying position information sent by the server, the position information indicating a position of the response audio clip in a response audio corresponding to the response request; synthesizing, based on the position information carried by respective received response audio clips, adjacent response audio clips into a response audio packet; playing the synthesized response audio packet.

In some embodiments, said playing the synthesized response audio packet includes: playing the response audio packet in response to a number of the response audio clip included in the response audio packet being greater than a preset number; playing the response audio packet in response to the number of the response audio clip included in the response audio packet being less than the preset number, and a duration between current moment and end time of playing of a last response audio packet reaching a first preset duration.

In some embodiments, the method further includes: playing the respective received response audio clips based on the position information, in response to the positions of respective received response audio clips being not adjacent and a duration between current moment and end time of playing of a last response audio packet reaching a second preset duration; discarding the received response audio clip during playing the respective received response audio clips, in response to a response audio clip being received, wherein the response audio clip is located before the position of the response audio clip that has been played or is being played.

In some embodiments, extending the first preset duration and/or increasing the preset number in response to a duration between a receiving time and an end time being greater than a second preset duration, wherein a new response audio clip is received at the receiving time and playing of a last response audio packet is ended at the end time.

In some embodiments, the method further includes: requesting, the target audio clip from the server in response to the positions of the respective received response audio clips being not adjacent and an un-received response audio clip being a target audio clip, the target audio clip being a response audio clip carrying a keyword in the response audio; synthesizing the target audio clip and a response audio clip located adjacent to the target audio clip into the response audio packet and playing the response audio packet in response to the target audio clip being received.

In some embodiments, said synthesizing, based on the position information carried by the respective received response audio clips, adjacent response audio clips into the response audio packet includes: determining a plurality of adjacent response audio clips based on the position information carried by the respective received response audio clips; performing semantic analysis on the plurality of adjacent response audio clips, and synthesizing the plurality of response audio clips into the response audio packet in response to the plurality of adjacent response audio clips constituting a short sentence.

In some embodiments, the method further includes: sending a persistent connection request to the server to indicate that the terminal is ready to receive the response audio clip; receiving a persistent connection response sent by the server to establish a persistent connection with the server; and receiving, through the persistent connection, the response audio clip carrying the position information sent by the server.

According to a second aspect of the disclosure, there is provided a method for playing audio applied to a server, and the method includes: receiving a response request sent by a terminal; obtaining, based on the response request, a plurality of response audio data; and sending the response audio clip to the terminal until finishing sending the plurality of response audio data in response to at least one piece of response audio data of the plurality of response audio data being synthesized into a response audio clip.

In some embodiments, the method further includes: receiving a request for a target audio clip sent by the terminal, the target audio clip being a response audio clip carrying a response keyword in the response audio; and sending the target audio clip to the terminal, causing the terminal to synthesize the target audio clip and a response audio clip adjacent to the target audio clip into a response audio packet, and play the response audio packet.

In some embodiments, before said sending the response audio clip to the terminal, the method further includes: receiving a persistent connection request sent by the terminal, the persistent connection request indicating that the terminal is ready to receive the response audio clip; establishing, in response to the persistent connection request sent by the terminal, a persistent connection with the terminal; and said sending the response audio clip to the terminal further comprises: sending, through the persistent connection, the response audio clip to the terminal.

According to a third aspect of the disclosure, there is provided a device for playing audio applied to a terminal, and the device includes: a first sending module, configured to send, a response request corresponding to a voice input to a server in response to detecting the voice input; a receiving module, configured to receive a response audio clip carrying position information sent by the server, the position information indicating a position of the response audio clip in a response audio corresponding to the response request; a synthesis module, configured to synthesize, based on the position information carried by respective received response audio clips, adjacent response audio clips into a response audio packet; a first playing module, configured to play the synthesized response audio packet, until finishing playing the response audio.

In some embodiments, the first playing module includes: a first playing sub-module, configured to play the response audio packet in response to a number of the response audio clip included in the response audio packet being greater than a preset number; a second playing sub-module, configured to play the response audio packet in response to the number of the response audio clip included in the response audio packet being less than the preset number and a duration between current moment and end time of playing of a last response audio packet reaching a first preset duration.

In some embodiments, the device further includes: a second play module, configured to play the respective received response audio clips based on the position information, in response to the positions of respective received response audio clips bing not adjacent and a duration between current moment and end time of playing of a last response audio packet reaching a second preset duration; a clearing module, configured to discard the received response audio clip during playing the respective received response audio clips, in response to a response audio clip being received wherein the response audio clip is located before the position of the response audio clip that has been played or is being played.

In some embodiments, the device further includes: an adjustment module, configured to extend the first preset duration and/or increase the preset number in response to a duration between a receiving time and an end time being greater than a second preset duration, wherein a new response audio clip is received at the receiving time and playing of a last response audio packet is ended at the end time.

In some embodiments, the device further includes: a request module, configured to request the target audio clip from the server, in response to the positions of the respective received response audio clips being not adjacent and an un-received response audio clip being a target audio clip, the target audio clip being a response audio clip carrying a keyword in the response audio; a third playing module, configured to synthesize the target audio clip and a response audio clip located adjacent to the target audio clip into a response audio packet, and play the response audio packet in response to the target audio clip being received,.

In some embodiments, the synthesis module includes: a determining sub-module, configured to determine, based on the position information carried by the respective received response audio clips, a plurality of adjacent response audio clips; a synthesis sub-module, configured to perform semantic analysis on the plurality of adjacent response audio clips, and synthesize, the plurality of adjacent response audio clips into the response audio packet in response to the plurality of adjacent response audio clips constituting a short sentence,.

In some embodiments, the device further includes: a second sending module, configured to send a persistent connection request to the server to indicate that the terminal is ready to receive the response audio clip; a persistent connection establishment module, configured to receive a persistent connection response sent by the server to establish a persistent connection with the server; and the receiving module includes: a receiving sub-module, configured to receive, through the persistent connection, the response audio clip carrying the position information sent by the server.

According to a fourth aspect of the disclosure, there is provided a device for playing audio configured to be applied to a server, and the device includes: a first receiving module, configured to receive a response request sent by a terminal; a data acquisition module, configured to obtain, based on the response request, a plurality of response audio data; a first sending module, configured to send, when at least one piece of response audio data of the plurality of response audio data is synthesized into a response audio clip, the response audio clip to the terminal until finishing sending the plurality of response audio data.

In some embodiments, the device further includes: a second receiving module, configured to receive a request for a target audio clip sent by the terminal, the target audio clip being a response audio clip carrying a response keyword in the response audio; a second sending module, configured to send the target audio clip to the terminal, causing the terminal to synthesize the target audio clip and a response audio clip adjacent to the target audio clip into a response audio packet, and play the response audio packet.

In some embodiments, the device further includes: a third receiving module, configured to receive a persistent connection request sent by the terminal, the persistent connection request indicating that the terminal is ready to receive the response audio clip; a persistent connection establishment module, configured to establish, in response to the persistent connection request sent by the terminal, a persistent connection with the terminal; and the first sending module includes: a sending sub-module, configured to send, through the persistent connection, the response audio clip to the terminal.

According to a fifth aspect of the embodiments of the disclosure, there is provided a terminal, including: a processor; a memory for storing processor-executable instructions; and the processor is configured to be executed to implement an operation performed by the method according to the first aspect of the disclosure.

According to a sixth aspect of the embodiments of the disclosure, there is provided a non-transitory computer-readable storage medium in which instructions, when executed by a processor of a terminal, may cause the terminal to execute the operation implemented by the method according to the first aspect of the disclosure.

According to a seventh aspect of the embodiments of the disclosure, there is provided a server, the server including: a processor; a memory, configured to store processor-executable instructions; and the processor is configured to be executed to perform an operation implemented by the method according to the second aspect of the disclosure.

According to an eighth aspect of the disclosure, there is provided a non-transitory computer-readable storage medium in which instructions, when executed by a processor of a terminal, cause the terminal to execute an operation implemented by the method according to the second aspect of the disclosure.

According to the embodiments of the disclosure, in response to detecting a voice input, a terminal sends a response request corresponding to the voice to the server; a response audio clip carrying position information sent by the server is received, the position information indicating a position of the response audio clip in a response audio corresponding to the response request; based on the position information carried by respective received response audio clips, adjacent response audio clips is synthesized into a response audio packet; the response audio packet is played in response to the response audio packet being synthesized. According to the disclosure, when the terminal sends the audio data to the server, the terminal does not need to wait for the server to organize a complete audio file before reading the complete audio file from the server; however, the terminal can directly synthesize the response audio packet based on the position information carried by respective response audio clip sent by the server. In this way, the audio clips are synthesized and played simultaneously, which improves response speed of the user's voice request, helps the user make faster decisions, and optimizes the user experience.

### BRIEF DESCRIPTION OF THE DRAWINGS

The drawings herein are incorporated into the specification and constitute a part of the specification, show embodiments that conform to the disclosure, and together with the specification are used to explain principles of the disclosure.
FIG. 1 is a flowchart of a method for playing audio according to embodiments of the disclosure;
FIG. 2 is a flowchart of a method for processing a response audio clip carrying a response keyword according to embodiments of the disclosure;
FIG. 3 is a flowchart of another method for playing audio according to embodiments of the disclosure;
FIG. 4 is a schematic structural diagram of a device for playing audio according to embodiments of the disclosure, the device being applied to a terminal;
FIG. 5 is a schematic structural diagram of a device for playing audio according to embodiments of the disclosure, the device being applied to a server;
FIG. 6 is a structural block diagram of a terminal according to embodiments of the disclosure;
FIG. 7 is a structural block diagram of a server according to embodiments of the disclosure.

### DETAILED DESCRIPTION

In order to enable those of ordinary skill in the art to better understand the technical solutions of the disclosure, the technical solutions in the embodiments of the disclosure will be described clearly and completely with reference to the accompanying drawings.

It should be noted that the terms "first" and "second" in the specification and claims of the disclosure and the above-mentioned drawings are used to distinguish similar objects, and not necessarily used to describe a specific sequence or order. It should be understood that number used in this way can be interchanged under appropriate circumstances so that the embodiments of the disclosure described herein can be implemented in an order other than those illustrated or described herein. Implementations described in the following exemplary embodiments do not represent all implementations consistent with the disclosure. Rather, they are merely examples of devices and methods consistent with some aspects of the disclosure as detailed in the appended claims.

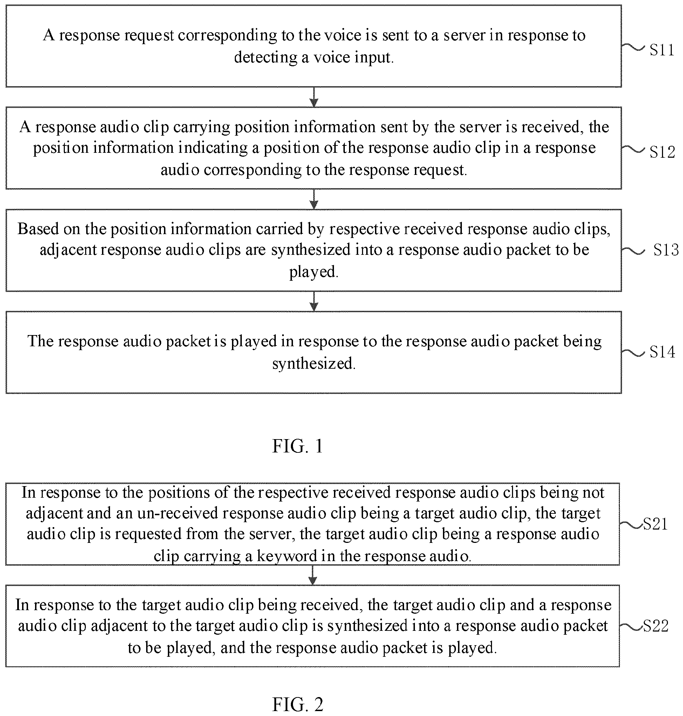

In order to overcome the problem of long delay in responding to the voice request of a user in related art, according to embodiments of the disclosure, a method for playing audio is provided, which is applied to a terminal, as shown in FIG. 1. FIG. 1 is a flowchart of a method for playing audio according to embodiments of the disclosure. As shown in FIG. 1, the method for playing audio of the disclosure includes the following steps.

In S11, a response request corresponding to a voice input is sent to a server in response to detecting the voice input.

In this embodiment, the terminal may be: a computer, a smart phone, a tablet, and the like. A client can be installed on the terminal, and the client can automatically recognize the voice from a user, convert the voice into corresponding audio data, and send the audio data as a response request to the server, while waiting for a response from the server for the audio data.

In S12, a response audio clip carrying position information sent by the server is received, the position information indicating a position of the response audio clip in a response audio corresponding to the response request.

In this embodiment, after the server receiving the audio data sent by the terminal, the server may first organize and obtain a target file corresponding to the audio data, then divide the target file into a plurality of clips, and generate a response audio clip for each of the plurality of clips, and finally send the generated plurality of response audio clips to the terminal to respond to the response request sent by the terminal. Each response audio clip carries position information, and the position information is indicating a position of the response audio clip in the response audio corresponding to the response request.

For example, a voice from a user may be: "How is the weather today?", the terminal converts the voice into audio data and sends it to the server. The target file obtained by the server after organization can be: "The weather is good today, the temperature is 25 degrees"; and then the target file can be divided into a plurality of clips, such as "Today", "The weather", "Is Good", "The Temperature is", "25", "Degrees", a total of 6 clips. Then position information can be added to each clip, thereby obtaining six response audio clips (a detailed process of obtaining of the response audio clips by adding position information by server is described below), and these 6 response audio clips constitute a complete response audio packet for the user's voice.

In S13, based on the position information carried by respective received response audio clips, adjacent response audio clips are synthesized into a response audio packet.

In S14, the response audio packet is played in response to the response audio packet being synthesized, until finishing playing the response audio.

In this embodiment, the terminal provides a receiving service and a playing service. Base on the receiving service, the response audio clip sent by the server can be received and buffered into a receiving queue. Based on the playing service, a plurality of adjacent audio clips can be read from the receiving queue and the plurality of adjacent response audio clips can be synthesized into a response audio packet to be played, and then play the audio packet.

In this embodiment, the position information carried by each response audio clip can be determined by numbering. Every time when a response audio clip is received by the terminal, the response audio clip is buffered into the receiving queue. The receiving queue buffers a plurality of response audio clips in an order according to the number corresponding to each response audio clip. For example, when the terminal receives 4 response audio clips currently, which are audio clips numbered as 3, 5, 6, and 7, and the terminal can synthesize, in an order (i.e., 3, 5, 6, and 7) of the numbers of the plurality of received response audio clip, the plurality of response audio clips having adjacent position information into a response audio packet to be played. That is, the above four response audio clips can be synthesized into a response audio packet to be played.

In an implementation, at step S13 may include: determining, based on the position information carried by the respective received response audio clips, a plurality of adjacent response audio clips; performing semantic analysis on the plurality of adjacent response audio clips, and synthesizing the plurality of response audio clips into the response audio packet, in response to the plurality of adjacent response audio clips constituting a short sentence.

In another implementation, at step S13 may include: playing the response audio packet to be played, in response to a number of the response audio clip included in the response audio packet to be played being greater than a preset number.

In order to make the sentence meaning of the synthesized response audio packet easy to understand, according to this embodiment, the plurality of adjacent response audio clips can be combined into a short sentence, or the number of consecutively numbered audio clips being a preset number can trigger the terminal to perform "synthesizing the response audio packet to be played". The preset number can be adjusted randomly according to quality of network where the terminal is currently located.

When the plurality of adjacent response audio clips constituting a short sentence can trigger the terminal to perform "synthesizing the response audio packet to be played", the terminal performs semantic detection on the received response audio clip, and once it is detected that a plurality of adjacent response audio clips can constitute a complete short sentence, the plurality of adjacent response audio clips can be read directly and synthesized into the response audio packet to be played, and then the synthesized response audio packet can be played.

For example, when there are three adjacent response audio clips in the receiving queue, namely "Today", "The weather", and "Is good". The terminal detects that these three clips can constitute a complete short sentence, i.e., "The weather is good today", and then combines these three response audio clips into the response audio packet to be played.

When the number of the adjacent audio clips being the preset number can trigger the terminal to perform "synthesizing the response audio packet to be played", the terminal periodically detects whether the number of consecutively numbered response audio clips buffered in the receiving queue is the preset number, and once it is detected that the number of consecutively numbered response audio clips buffered in the receiving queue is the preset number, the consecutively numbered audio clips of which the number is the preset number can be directly read and synthesizes into the response audio packet to be played, and then the synthesized response audio packet can be played. After the playing, it is continued to detect whether the number of consecutively numbered response audio clips buffered in the receiving queue is the preset number, and repeat the above process until all the response audio clips sent by the server are played.

For example, when there are five consecutively numbered response audio clips in the receiving queue, which are the response audio clips with position number 3 to 7, if the preset number is set to be 5, and the terminal detects that the preset number of the consecutively numbered response audio clips has been buffered in the receiving queue, and the response audio clips with position number 3 to 7 are directly read and synthesized into the response audio packet to be played, and then the synthesized response audio packet is played. In the embodiment of this disclosure, the terminal sends audio data to the server according to the voice from the user, and receives the response audio clips returned by the server. When a preset number of response audio clips consecutively numbered is received, based on the ascending order of the consecutive numbers, the terminal can synthesize the preset number of response audio clips consecutively numbered into the response audio packet to be played and plays it, until finishing playing the response audio.

The determining the adjacent response audio clips can be achieved through the following steps.

In A1, an audio clip group is determined from the plurality of received response audio clips.

In A2, a maximum number information is determined in the audio clip group;

In A3, a response audio clip that has number information less than the maximum number information and that is not currently received is determined as an audio clip that has number information which is continuous with the number information of the plurality of received response audio clips.

The audio clip group can be determined as follows.

A plurality of received audio clips can be arranged in ascending order of numbers thereof, and it can be determined, according to the ascending order of the numbers, whether a difference between numbers of two audio clips located adjacent to each other is greater than a preset difference. When the difference is greater than the preset difference, a spacer is added between the two adjacent audio clips, and N (1≤N<the preset number) audio clips before the spacer can be determined as the audio clip group.

In an actual implementation scenario, due to network fluctuations, a terminal generally cannot receive audio clips strictly in order of numbers thereof. Therefore, there are many scenarios for audio clips buffered in the receiving queue. The following will take the preset number of 5 as an example to list several common implementation scenarios for determining an audio clip of which the number is consecutive to the numbers of a plurality of received audio clips.

In a first implementation scenario, audio clips numbered as 8, 9, 11, and 12 are received in the receiving queue. According to the above steps A1-A3, taking the preset difference of 3 and the preset number of 5 as an example, no spacer is between the received audio clips with numbers 8, 9, 11, and 12. Therefore, a plurality of audio clips with numbers 8, 9, 11, and 12 are determined as an audio clip group; and then it is determined that the largest number in the audio clip group is 12; finally, all un-received audio clips with the number less than 12 are determined as the audio clips consecutive to the plurality of received audio clips (i.e., the audio clips of which the number is consecutive with the numbers of the plurality of received audio clips). For example, the all un-received audio clips may be an audio clip numbered as 10, or may be audio clips numbered as 6, 7, or 10 or other audio clips.

In a second implementation scenario, audio clips numbered as 9, 11, 12, 16, and 17 are received in the receiving queue. According to the above steps A1-A3, taking the preset difference of 3 and the preset number of 5 as an example, among the received audio clips with numbers 9, 11, 12, 16, and 17, the difference between number 12 and number 16 is 4, which is greater than the preset difference 3, i.e., there is a spacer. Therefore, a plurality of audio clips with numbers 9, 11, and 12 are determined as an audio clip group; then it is determined that the largest number in the audio clip group is 12; finally, all un-received audio clips with the number less than 12 are determined as the audio clips consecutive to the plurality of received audio clips. For example, the all un-received audio clips may be an audio clip numbered as 10, may be audio clips numbered as 8 and 10, or may be audio clips numbered as 6, 7, and 10 or other audio clips.

In the third implementation scenario, audio clips numbered as 9, 11, 12, 16, 17 and 18 are received in the receiving queue. According to the above steps A1-A3, taking the preset difference of 3 and the preset number of 5 as an example, among the received audio clips with numbers 9, 11, 12, 16, 17 and 18, the difference between number 12 and number 16 is 4, which is greater than the preset difference 3, i.e., there is a spacer. Therefore, a plurality of audio clips with numbers 9, 11, and 12 are determined as an audio clip group; then it is determined that the largest number in the audio clip group is 12; finally, all un-received audio clips with the number less than 12 are determined as the audio clips consecutive to the plurality of received audio clips. For example, the all un-received audio clips may be an audio clip numbered as 10, may be audio clips numbered as 8 and 10, or may be audio clips numbered as 7, 8, and 10 or other audio clips.

In a fourth implementation scenario, audio clips numbered as 4, 9, 11, 12, 16, 17 and 18 are received in the receiving queue. According to the above steps A1-A3, taking the preset difference of 3 and the preset number of 5 as an example, among the received audio clips with numbers 4, 9, 11, 12, 16, 17 and 18, the difference between number 4 and number 9 is 5, which is greater than the preset difference 3, i.e., there is a spacer. Therefore, an audio clip with number 4 is determined as an audio clip group; then it is determined that the largest number in the audio clip group is 4; finally, all un-received audio clips with the number less than 4 are determined as the audio clips consecutive with the received audio clip. For example, the all un-received audio clips may be an audio clip numbered as 3, or may be audio clips numbered as 2 and 3.

According to the disclosure, when the terminal sends the audio data to the server, the terminal does not need to wait for the server to organize a complete audio file (i.e., an audio file obtained by synthesizing all audio clips of the response audio) before reading the complete audio file from the server; however, the terminal can directly synthesize the response audio packet based on the position information carried by respective response audio clip sent by the server. In this way, the audio clips are synthesized and played simultaneously, which can improve response speed of the user's voice request, help the user make faster decisions, and optimize the user experience.

During the actual implementation, the loss of the response keywords in the audio file will cause the terminal to fail to correctly convey information to the user through voice (e.g., in the above target file "The weather is good today, the temperature is 25 degrees", "Is good" and "25" are the response keywords. When the response audio clips corresponding to the above two response keywords are missing, the terminal cannot convey accurate weather conditions to the user). Based on the above problems, in embodiments of the disclosure, the response audio clips can be as classified into at least two types, one is the response audio clip carrying common information, and the other is the response audio clip carrying response keywords.

The process of processing the response audio clips carrying a response keyword in this disclosure will be described in detail below.

FIG. 2 is a flowchart of a method for processing a response audio clip carrying a response keyword according to an embodiment of the disclosure. Referring to FIG. 2, the method for playing a response audio clip provided by the disclosure further includes the following steps.

In S21, in response to the positions of the respective received response audio clips being not adjacent and an un-received response audio clip being a target audio clip, the target audio clip is requested from the server, the target audio clip being a response audio clip carrying a keyword in the response audio.

In S22, in response to the target audio clip being received, the target audio clip and a response audio clip adjacent to the target audio clip is synthesized into a response audio packet to be played, and the response audio packet is played.

In this embodiment, for ease of description, a response audio clip carrying the response keyword is named the target audio clip, which means that the response audio clip carries a preset value of a response keyword.

According to the disclosure, the target audio clip can be obtained as follows. After a plurality of clips is obtained by dividing the target file, in one implementation, each clip can be assigned a score representing response importance, and a response audio clip corresponding to a clip with a score greater than a preset score can be determined as the target audio clip (i.e., the response audio clip that carries a response keyword); and a response audio clip corresponding to a clip with a score not greater than the preset score can determined as a normal audio clip (i.e., the response audio clip that does not carry a response keyword). In another implementation, semantic analysis can be performed on each clip, and a target audio clip (i.e., a response audio clip carrying a response keyword) can be determined from respective clips according to semantic analysis result and the response request sent by the terminal.

In embodiments of the disclosure, the response audio clip adjacent to the plurality of received response audio clips has the following characteristics: the response audio clip is not received by the terminal; and the response audio clip and parts or all of the plurality of received response audio clips may constitute a new response audio clip in which clips are adjacent clips.

After determining the audio clip (i.e., the number of the audio clip) is consecutive to the plurality of received audio clips, it can be determined whether the audio clip consecutive to the plurality of received audio clips is the target audio clip, and when it is the target audio clip, it means that there is still un-received audio clip carrying a response keyword. In order to accurately convey information to a user, the target audio clip also needs to be obtained. In a process of obtaining the target audio clip, it may also receive other normal audio clip consecutive to the target audio clip.

In an actual implementation scenario, a notification message that it is ready to receive audio clips can be sent to the server from the terminal, and then the server can first read all target audio clips from the message queue and send them to the terminal, and then read normal audio clips and send them to the terminal. Thereby increasing the time for receiving the target audio clip, ensuring that all target audio clips are received by the terminal with the greatest probability, and improving accuracy of the information conveyed to the user during the voice playback of the terminal.

Correspondingly, the above step S13 may include: synthesizing, in ascending order, when the target audio clip is consecutive to the plurality of audio clips, the target audio clip and the plurality of audio clips consecutive to the target audio clip into the response audio packet to be played.

For example, in the first implementation scenario described above, there are already audio clips numbered as 8, 9, 11, and 12 in the audio clip group. It is assumed that all the audio clips that have not been received are audio clips numbered as 6, 7, and 10, and only the audio clip numbered as 7 is the target audio clip, and the audio clips numbered as 6 and 10 are normal audio clips, then the terminal can wait to receive the audio clip numbered as 7 During the process for waiting to receive the audio clip numbered as 7, audio clips numbered as 6 and 10 may also be received. Assuming that audio clips numbered as 6 to 12 are finally received, the terminal reads 5 audio clips numbered as 6 to 10 from the receiving queue, and synthesizes these 5 audio clips into the audio packet to be played.

According to embodiments of the disclosure, in order to shorten a delay in responding to a user's voice request, the following forced playing strategy is further provided. When any of the following conditions are met, a forced playing strategy needs to be performed:

A first condition is as follows: when a first preset duration has passed, the preset number of audio clips having consecutive numbers have not been received, and the audio clip consecutive to the plurality of received audio clips is not the target audio clip.

A second condition is as follows: the target audio clip has not been received within a second preset duration.

A third condition is as follows: within the second preset duration, the target audio clip is received, but a playing condition of a second preset number of consecutively numbered audio clips is not met.

For the first condition, in the first implementation scenario listed above, taking the preset number of 5 as an example, when the un-received audio clips are audio clips numbered as 6, 7, and 10, and each of the audio clips numbered as 6, 7, and 10 is an ordinary audio clip, so the receiving service of the terminal will not receive the audio clips numbered as 6, 7, and 10 any longer, but a forced playing instruction can be sent to the playing service, so that the playing service can read, in an ascending order of the numbers (i.e., in an order of 8, 9, 11, 12), the audio clip with the smallest number from the receiving queue in turn and synthesize the audio clips into a corresponding response audio packet to be played for a forced playing. If the receiving service receives audio clips numbered as 10 and 13 when a response audio packet corresponding to the audio clip numbered as 8 is forced to be played, the receiving service can send an instruction for stopping the forced playing to the server and inform the playing service to play the audio clips numbered as 9-13. Since the audio clips numbered 9-13 meet the condition of a preset number of consecutively numbered audio clips, the playing service can read the audio clips numbered as 9-13 and synthesize the audio clips numbered as 9-13 into a response audio packet to be played and play the response audio packet.

For the second condition, in the second implementation scenario listed above, taking the preset number of 5 as an example, when the un-received audio clips are audio clips numbered as 8, 10, and each of the audio clips numbered as 8, 10 is a target audio clip, the receiving service of the terminal continues to wait for the second preset duration to receive audio clips numbered as 8, 10, and if the audio clips numbered as 8, 10 are not received within the second preset duration, the receiving service can give up waiting for receiving audio clips numbered as 8, 10, and send a forced playing instruction to the playing service, so that the playing service can read, in an ascending order of the numbers (i.e., in an order of 9, 11, 12, 16, 17), the audio clip with the smallest number from the receiving queue in turn and synthesize the audio clips into a corresponding response audio packet to be played for a forced playing.

For the third condition, in the third implementation scenario listed above, taking the preset number of 5 as an example, when the un-received audio clips are audio clips numbered 8 and 10, and the audio clip numbered as 8 is a target audio clip, the audio clip numbered 10 is a normal audio clip, if, within the second preset duration, the receiving service receives the audio clip numbered as 8 but the audio clip numbered 10 is not received, the condition of the preset number of consecutively numbered audio clips is still not met, but a forced playing instruction can still sent to the playing service, so that the playing service can read, in an ascending order of the numbers (i.e., in an order of 8, 9, 11, 12, 16, 17, 18), the audio clip with the smallest number from the receiving queue in turn and synthesize the audio clips into a corresponding response audio packet to be played for a forced playing.

The embodiments of the disclosure provide a forced playing strategy, which shortens the delay of the terminal in responding to the user's voice request, so that the user can obtain the requested information in time and make a decision, thereby optimizing the user experience.

In specific implementations, a forced playing strategy may include but not limited to the following strategies.

According to a first forced playing strategy, in response to the number of the response audio clip included in the response audio packet being less than the preset number, and a duration between current moment and end time of playing of a last response audio packet reaching a first preset duration, the response audio packet can be played.

In various embodiments of the disclosure, in order to shorten the delay in responding to the user's voice request, a threshold is set for waiting time based on experience, that is, the first preset duration.

In this embodiment, the duration between the current moment and the end time of playing of a last response audio packet is determined as follows: the playing service of the terminal can record a start moment when starting to play the response audio packet, and send the starting playing time to the receiving service, so that the receiving service can determine the waiting time since the last time a audio clip was played by the playing service according to the start moment and the current moment.

For example, the first preset duration is set to be 5 seconds. When 3 response audio clips are received, and no other response audio clips are received subsequently, and the duration between the current moment and the end time of playing of a last response audio packet reaches 5 seconds, in order to avoid the user from waiting, even though the number of currently received response audio clips does not reach the preset number, the currently received response audio clips should be synthesized into a response audio packet to be played, and the response audio packet can be played.

In this embodiment, when performing a forced playing, it is not necessary to consider whether the number of audio clips for the forced playing meets the preset number, and the forced playing continues until the preset number of adjacent audio clips are detected again.

Taking into account a problem that a response keyword may be lost in an actual implementation process, when the terminal has waited for the first preset duration, if the a plurality of received audio clips do not meet the condition of a preset number of consecutively numbered audio clips, it is determined whether the audio clip consecutive to the plurality of received audio clip is the target audio clip, if yes, terminal will continue to wait for the target audio clip until the target audio clip is received and after receiving a plurality of audio clips consecutive to the target audio clip, the plurality of consecutive audio clips corresponding to the target audio clip are synthesized into a response audio packet to be played, and the response audio packet can be played. In this way, the probability of the response keyword being lost is reduced, and the accuracy of the information conveyed to the user can be ensured.

In order to avoid waiting too long for the target audio clip, the following forced playing strategy 2 can also be adopted.

According to the forced playing strategy 2, in response to the received response audio clips being not adjacent, and a duration between the current moment and the end time of playing of a last response audio packet reaching the second preset duration, the received audio clips are played based on the position information.

As mentioned above, in order to ensure the accuracy of the information conveyed by the terminal to the user, audio clips in this disclosure as classified into two types: a target audio clip (i.e., an audio clip having a response keywords) and a normal audio clip (i.e., an audio clip not having a response keyword). If the target audio clip is not received within the first preset duration, it is continued to receive the target audio clip within the second preset duration, and when a plurality of consecutively numbered audio clips including the target audio clip are received, the plurality of consecutively numbered audio clips including the target audio clip are read and synthesized into a response audio packet to be played, and the response audio packet is played. If the target audio clip is still not received within the second preset time period, no further waiting is continued, and based on the position information, the received response audio clips are synthesized into a response audio packet to be played and the response audio packet is played.

For example, a voice from a user may be: "How is the weather today?", the terminal converts the voice into audio data and sends it to the server. The target file obtained by the server after organization can be: "The weather is good today, the temperature is 25 degrees"; and then the target file can be divided into a plurality of clips, such as "Today", "The weather", "Is Good", "The Temperature is", "25", "Degrees", a total of 6 clips. Then the position information can be added to each clip, thereby obtaining six response audio clips. Due to network fluctuations caused by network instability, the server is delayed in sending the response audio clips. By the end of the first preset duration, only "Today", "Is Good", "The Temperature is", and "Degrees" are received by the terminal, and the response audio clip carrying the key word "25" was missing. The response audio clip with the keyword "25", because the missing response audio clip is the target audio clip, it should be continued to wait to receive the target audio clip within the second preset time period. If at the end of the second preset duration, the response audio clip of "25" is still not received, the four received response audio clips "Is good today, the temperature is degrees" are forced to be played to avoid users waiting too long.

In this embodiment of the disclosure, each target audio clip carries a second preset duration set in advance. When the terminal determines that the audio clip consecutive to the plurality of received audio clips is the target audio clip, it first acquires the second preset duration of the target audio clip, and The starting moment when the second preset duration is enabled is the moment when the waiting duration exceeds the first preset duration, that is, the moment when it is determined whether the audio clip consecutive to the plurality of received audio clip numbers is the target audio clip.

In the embodiment of the disclosure, the target audio clip may be further divided into a plurality of levels according to the importance of the response voice, and different second preset durations can be set for the target audio clips of different levels. Whether to divide the target audio clip into a plurality of levels and how to set the importance interval corresponding to each level can be flexibly set according to actual application scenarios, which are not specific limited herein.

In this disclosure, by setting a second preset duration for each target audio clip, the probability of the terminal being losing the target audio clip can be reduced while the delay of the terminal in responding to the user's voice request can be shortened, thereby ensuring the accuracy of the information conveyed by the terminal to the user and optimizing the user experience.

In combination with the above embodiments, due to the use of the forced playing strategy, the terminal will inevitably have a phenomenon that after a certain audio clip has been played, an audio clip located before the position of the played audio clip is received. If this kind of audio clip is not processed in time, it will cause confusion in voice playback. Therefore, in order to ensure the normal playback of the voice under the forced playing strategy, this disclosure also provides a method for clearing out an expired audio clip used in conjunction with the forced playing strategy.

In some embodiments, in the process of playing each received response audio clip, if a response audio clip located before the position of the response audio clip that has been played or is being played is received, the received response audio clip can be discarded.

In this embodiment, each time the receiving service of the terminal receives a new audio clip, the number of the audio clip currently being played can be obtained from the playing service, if the new audio clip has a number less than the number of the audio clip currently being played, the new audio clip can be directly discarded; and if the new audio clip has a number not less than the number of the audio clip currently being played, the new audio clip can be buffered into the receiving queue.

For example, when the audio clips numbered as 7, 8, 10, and 13 are buffered in the receiving queue and the playing service is performing the forced playing strategy, assuming that the playing service is forcibly playing the audio clip numbered as 8, and an audio clip numbered 6 is received, it is determined that the number of the audio clip numbered as 6 is less than the number of the audio clip numbered as 8 which is being played, so the audio clip numbered as 6 is directly discarded; if an audio clip numbered 9 is received, it is determined that the number of the audio clip numbered 9 is greater than the number of the audio clip numbered as 8 which is being played, so the audio clip numbered as 9 is buffered into the receiving queue.

The embodiment of the disclosure provides a method for clearing out expired audio clips corresponding to the forced playing strategy, which avoids confusion in voice playback of the terminal.

In actual implementation scenarios, the quality of the information channel used for audio clip transmission between the server and the terminal will fluctuate with network fluctuations. Therefore, in order to further enhance the user experience, for the terminal, this disclosure also provides a receiving strategy of an audio clip corresponding to the current network quality.

The embodiment of the disclosure also provides a receiving method for dynamically adjusting audio clips.

In some embodiments, the first preset duration can be extended and/or the preset number can be increased, in response to a duration between a receiving time and an end time being greater than a second preset duration, and a new response audio clip is received at the receiving time and playing of a last response audio packet is ended at the end tim.

In the embodiment of the disclosure, the duration between a receiving time when a new response audio clip is received and the end time of the playing of the last response audio packet may reflect the communication quality. The receiving service of the terminal may preset a second preset duration, and determine network quality corresponding to the preset duration as a preset quality.

In an embodiment, when the duration between the time when a new response audio clip is received by the receiving service of the terminal and the end time of playing of a last response audio packet is greater than the second preset duration, it is determined that the current communication quality is lower than the preset quality, and the communication quality is low. Then the receiving service can perform any of the following methods: increasing the preset number, increasing the first preset duration, increasing the preset number and increasing the first preset duration.

In another embodiment, when the duration between the time when a new response audio clip is received by the receiving service of the terminal and the end time of the playing of the last response audio packet is smaller than the second preset duration, it is determined that the current communication quality is not lower than the preset quality , and the communication quality is high. Then, the receiving service can perform any of the following methods: reducing the preset number, reducing the first preset duration, reducing the preset number, and reducing the first preset duration.

In the first embodiment above, when the current communication quality is low, without adjusting the audio clip receiving mode, because the receiving service receives the audio clip at a low speed, the playing service needs to wait a long time to play a new response audio packet after playing the response audio packet to be played, which leads to the final played voice to be severely stuttered, which decreases the user experience. However, the strategy of increasing the preset number and/or extending the first preset duration proposed in this disclosure can better avoid this problem. In the case of poor network quality, the receiving service does not perform the synthesizing and playing before a number of audios clips are received, which can effectively ensure the fluency of the played voice.

In the second embodiment above, when the current communication quality is high, because the receiving service receives audio clips at a fast speed, the playing service reduces the preset number and/or extends the first preset duration, which can fully maximize the benefit of receiving speed, the audio clips are continuously read from the receiving queue and synthesized and played. When the network quality is higher than the ideal preset quality, the effect of responding to the user's voice request almost in real time can be achieved.

In the embodiments of the disclosure, the terminal can detect the network quality in real time, and adjust the audio clip receiving strategy adaptively according to the network quality to realize the dynamic adjustment of the audio clip playing strategy. That is, when the network quality is poor, it can guarantee the fluency of the voice played, when the network quality is good, it can effectively shorten the delay in responding to the user's voice request, accelerate the response speed, and greatly optimize the user experience.

In combination with the above embodiments, in another embodiment of the disclosure, before the step S12, the following steps are further included: sending a persistent connection request to the server to indicate that the terminal is ready to receive the response audio clip; receiving a persistent connection response sent by the server to establish a persistent connection with the server; said receiving the response audio clip carrying the position information sent by the server including: receiving, through the persistent connection, the response audio clip carrying the position information sent by the server.

In some embodiments, in response to detecting a voice input, the terminal sends a response request corresponding to the voice input to the server. When the terminal receives the response instruction from the server and determines that the response audio can be received and played, the terminal cam send a persistent connection request to the server, and when the terminal receives the persistent connection response sent by the server, a persistent connection can be established with the server. Then the terminal receives the response audio clip carrying the position information sent by the server through this persistent connection service.

In another implementation, the terminal may also perform the following steps: receiving text information corresponding to the audio file sent by the server; displaying the text information.

In this disclosure, in order to further ensure the accuracy of the information conveyed by the terminal to the user, after the terminal sends the audio data corresponding to the voice to the server, it can also receive the text information of the audio file for responding to the voice returned by the server, and display the text information through the terminal interface.

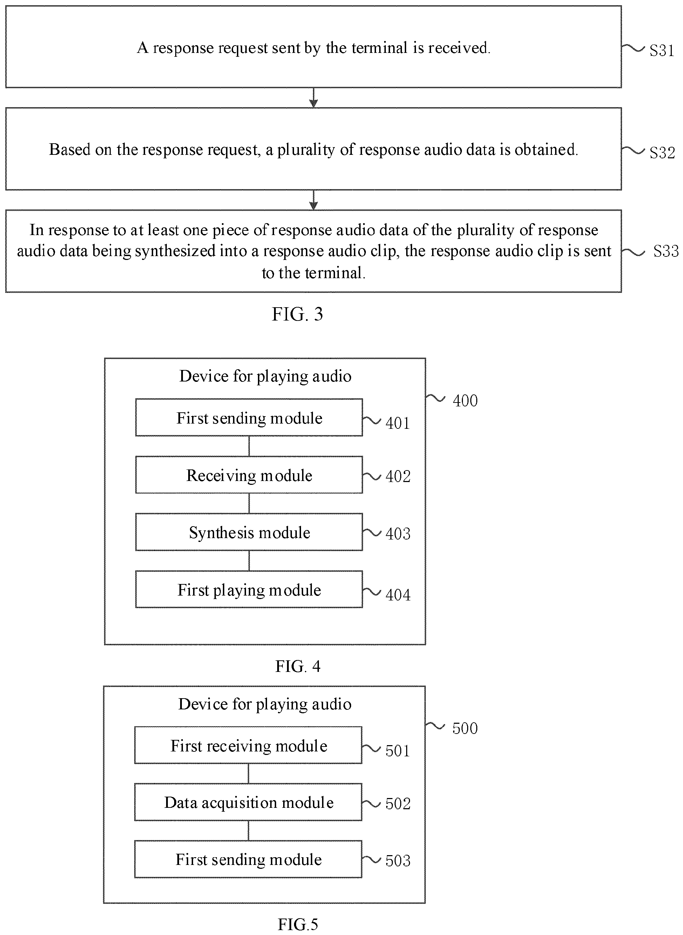

The disclosure also provides a method for playing audio, which is applied to a server, as shown in FIG. 3. FIG. 3 is a flowchart of another method for playing audio according to embodiments of the disclosure. Referring to FIG. 3, the method for playing audio provided by the disclosure includes the following steps.
At step S31, a response request sent by the terminal is received.
At step S32, based on the response request, a plurality of response audio data is obtained.
At step S33: every time when at least one piece of response audio data of the plurality of response audio data is synthesized into a response audio clip, the response audio clip is sent to the terminal until finishing sending the plurality of response audio data.

In the embodiment of the disclosure, the target file is divided into a plurality of clips according to the form of word to obtain a plurality of words, and each clip is coded, that is, each word is encoded to obtain a plurality of audio clips.

For example, when the audio data is "How is the weather today", the target file obtained may be "The weather is good today, the temperature is 25 degrees". Words obtained by the division can be: "Today", "The weather", "Is good", "The temperature is", "25", and "degrees". Therefore, six audio clips can be obtained by encoding the above 6 words.

In this embodiment, the server receiving the response request sent by the terminal may include: receiving a request for a target audio clip sent by the terminal, the target audio clip being a response audio clip carrying a response keyword in the response audio; sending the target audio clip to the terminal, causing the terminal to synthesize the target audio clip and a response audio clip adjacent to the target audio clip into a response audio packet to be played, and play the response audio packet.

For example, the server receives the target clip request sent by the terminal, and the target clip is "25". The server immediately sends the clip to the terminal. After receiving the clip, the terminal combines the clip with the adjacent response audio clips "The temperature is" and "Degrees" into the response audio packet to be played: "The temperature is 25 degrees", and it can be played.

In this embodiment, before the server sending the response audio clip to the terminal, it may further include: receiving a persistent connection request sent by the terminal, the persistent connection request indicating that the terminal is ready to receive the response audio clip; establishing, in response to the persistent connection request sent by the terminal , a persistent connection with the terminal; said sending the response audio clip to the terminal including: sending, through the persistent connection, the response audio clip to the terminal.

In some embodiments, after receiving the response request sent by the terminal, the server starts to synthesize the response voice clip, and then can send a response instruction to the terminal, and then receive the persistent connection request sent by the terminal, and send the persistent connection response to the terminal to establish a persistent connection with the terminal, and finally the server can send the response audio clip to the terminal through this persistent connection service.

In this embodiment, after the server receives the audio data sent by the terminal and obtains the target file, the method may further perform the following steps: sending the text information corresponding to the audio file to the terminal, so that the terminal displays the text information; adding position information to the plurality of audio clips according to the order of generating the plurality of audio clips.

For example, for the above six audio clips, according to the order in the target file, the position information obtained sequentially can be 1 to 6.

A plurality of response audio clips carrying position information are sent to the terminal, so that based on the position information, the response audio packet to be played can be synthesized and played by the terminal.

In one embodiment, after the server organizes and obtains the target file, it can return the target file to the terminal so that the terminal can display it to the user in text. In another embodiment, after the terminal initiates a voice request, it can also provide a voice play button. When it is detected that the user clicks the voice play button, it sends a notification message to the server that the terminal is ready to receive the audio clip, and the terminal establishes a persistent connection with the server and receives the plurality audio clips sent by the server through the persistent connection.

Considering that the user may click the voice play button after a long time, therefore, according to the embodiment of the disclosure, when the server encodes audio clips, if the server does not receive the notification message from the terminal that the terminal is ready to receive audio clips, the server can temporarily buffer the plurality of audio clips that have been encoded in the message queue, and read each audio clip from the message queue and send it to the terminal when receiving the notification message that the terminal is ready to receive the audio clips,.

The audio clips provided by this disclosure have the following effective effects.

Firstly, compared with the common method of playing voice only after downloading the complete audio file in the related technology, this disclosure adopts the method of synthesizing while playing, which can significantly reduce the delay in responding to the user's voice request and improve the speed of the terminal responding to the user's voice request, which provides great convenience for users to make decisions.

Secondly, the forced playing strategy can avoid users waiting for a long time, so that users can get the voice response to their voice requests as soon as possible.

Thirdly, using the keyword response strategy, the audio clips are divided into the target audio clips and normal audio clips, and a longer time is provided for receiving the target audio clips, and the delay in responding to the user's voice request can be controlled to be within a reasonable range, and the probability of losing the target audio clip can be reduced, and thus the accuracy of the information conveyed to the user is ensured.

Fourthly, that adjusting the way the terminal receives audio clips according to the network quality can realize the dynamic adjustment of the playing strategy of the audio clips. When the network quality is poor, it can ensure the fluency of the played voice, and when the network quality is good, it can effectively shorten the delay in responding to the user's voice request.

Based on the same concept, an embodiment of the disclosure provides a device for playing audio 400. Referring to FIG. 4, FIG. 4 is a schematic structural diagram of a device for playing audio according to embodiments of the disclosure, the device being applied to a terminal. As shown in FIG. 4, the device 400 for playing audio includes: a first sending module 401, configured to send a response request corresponding to a voice to a server in response to detecting the voice input; a receiving module 402, configured to receive a response audio clip carrying position information sent by the server, the position information indicating a position of the response audio clip in a response audio corresponding to the response request; a synthesis module 403, configured to synthesize, based on the position information carried by respective received response audio clips, adjacent response audio clips into a response audio packet to be played; a first playing module 404, configured to play the response audio packet every time when the response audio packet is synthesized, until finishing playing the response audio.
The first playing module 404 includes: a first playing sub-module, configured to play, when a number of the response audio clip included in the response audio packet to be played is greater than a preset number, the response audio packet to be played; a second playing sub-module, configured to play, when the number of the response audio clip included in the response audio packet to be played is less than the preset number, and a duration between current moment and end time of a last playback reaches a first preset duration, the response audio packet to be played.

In some embodiments, the device 400 for playing audio further includes: a second play module, configured to play, based on the position information, when the positions of respective received response audio clips are not adjacent and a duration between current moment and end time of playing of a last response audio packet reaches a second preset duration, the respective received response audio clips; a clearing module, configured to discard, during playing the respective received response audio clips, when a response audio clip located before the response audio clip that has been played or is being played is received, the received response audio clip.
In some embodiments, the audio playback device 400 further includes: an adjustment module, configured to extend the first preset duration and/or increasing the preset number in response to a duration between a receiving time and an end time being greater than a second preset duration, and a new response audio clip is received at the receiving time and playing of a last response audio packet is ended at the end time.

In some embodiments, the device 400 for playing audio further includes: a request module, configured to request the target audio clip from the server,, in response to the positions of the respective received response audio clips being not adjacent and an un-received response audio clip being a target audio clip, the target audio clip being a response audio clip carrying a keyword in the response audio; a third playing module, configured to synthesize, when the target audio clip is received, the target audio clip and a response audio clip located adjacent to the target audio clip into a response audio packet to be played, and play the response audio packet.

In some embodiments, the synthesis module 403 further includes: a determining sub-module, configured to determine, based on the position information carried by the respective received response audio clips, a plurality of adjacent response audio clips; a synthesis sub-module, configured to perform semantic analysis on the plurality of adjacent response audio clips, and synthesize the plurality of adjacent response audio clips into the response audio packet, in response to the plurality of adjacent response audio clips constituting a short sentence.

In some embodiments, the device 400 for playing audio further includes: a second sending module, configured to send a persistent connection request to the server to indicate that the terminal is ready to receive the response audio clip; a persistent connection establishment module, configured to receive a persistent connection response sent by the server to establish a persistent connection with the server;

The receiving module 402 includes: a receiving sub-module, configured to receive, through the persistent connection, the response audio clip carrying the position information sent by the server.

Regarding the device for playing audio in the embodiments above, the specific methods for performing operations of each module have been described in detail in the embodiments of the method for playing audio applied to the terminal, and detailed description will not be repeated here.

An embodiment of the disclosure provides a terminal, including: a processor; a memory for storing processor-executable instructions; and the processor is configured to perform the method for playing audio applied to the terminal according to the disclosure.

Another embodiment of the disclosure provides a non-transitory computer-readable storage medium. The instructions in the storage medium, when executed by the processor of the terminal, cause the terminal to perform the method for playing audio applied to the terminal, according to the disclosure of the disclosure.

Based on the same concept, an embodiment of the disclosure provides a device 500 for playing audio. Referring to FIG. 5, FIG. 5 is a schematic structural diagram of a device for playing audio according to embodiments of the disclosure, the device being applied to a server. As shown in FIG. 5, the device 500 for playing audio includes: a first receiving module 501, configured to receive a response request sent by a terminal; a data acquisition module 502, configured to obtain, based on the response request, a plurality of response audio data; a first sending module 503, configured to send the response audio clip to the terminal until finishing sending the plurality of response audio data, in response to at least one piece of response audio data of the plurality of response audio data being synthesized into a response audio clip.

In some embodiments, the device 500 for playing audio further includes: a second receiving module, configured to receive a request for a target audio clip sent by the terminal, the target audio clip being a response audio clip carrying a response keyword in the response audio; a second sending module, configured to send the target audio clip to the terminal, causing the terminal to synthesize the target audio clip and a response audio clip adjacent to the target audio clip into a response audio packet to be played, and play the response audio packet.

In some embodiments, the device 500 further includes: a third receiving module, configured to receive a persistent connection request sent by the terminal, the persistent connection request indicating that the terminal is ready to receive the response audio clip; a persistent connection establishment module, configured to establish, in response to the persistent connection request sent by the terminal, a persistent connection with the terminal.

The first sending module 503 includes: a sending sub-module, configured to send, through the persistent connection, the response audio clip to the terminal.

Regarding the device for playing audio in the above embodiments, the specific method in which each module performs operations has been described in detail in the embodiments of the method for playing audio applied to the server, and will not be repeated here.

An embodiment of the disclosure provides a server, including: a processor; a memory for storing processor-executable instructions; and the processor is configured to perform the operations performed by the above method for playing audio applied to the server in the disclosure.

Another embodiment of the disclosure provides a non-transitory computer-readable storage medium. The instructions in the storage medium, when executed by the processor of the terminal, cause the terminal to perform the method for playing audio, which is applied to the server, according to the disclosure.

Regarding the device in the above embodiments, the specific method in which each module performs the operation has been described in detail in the embodiments of the method, and a detailed description will not be given here.

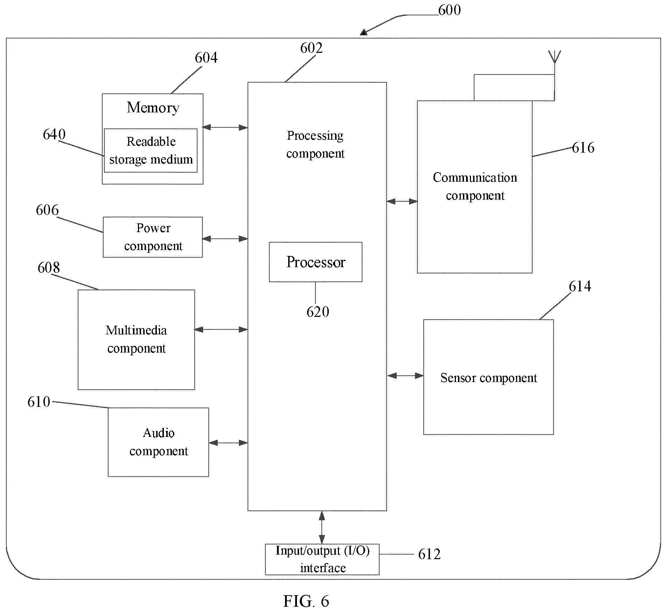

Referring to FIG. 6, FIG. 6 is a structural block diagram of a terminal according to embodiments of the disclosure. For example, the terminal 600 may include one or more of the following components: a processing component 602, a memory 604, a power component 606, and a multimedia component 608, an audio component 610, an input/output (I/O) interface 612, a sensor component 614, and a communication component 616. A non-transitory computer-readable storage medium 640 is stored in the memory 604. In some embodiments, the readable storage medium 640 may be a non-transitory computer-readable storage medium. For example, the non-transitory computer-readable storage medium 640 may be a ROM, Random Access Memory (RAM), CD-ROM, magnetic tape, floppy disk and optical data storage device, and the like.

The processing component 602 generally controls the overall operations of the terminal 600, such as operations associated with display, telephone calls, data communications, camera operations, and recording operations. The processing component 602 may include one or more processors 620 to execute instructions of the readable storage medium 640, so that the terminal 600 can complete all or parts of the steps of a certain method above. In addition, the processing component 602 may include one or more modules to facilitate the interaction between the processing component 602 and other components. For example, the processing component 602 may include a multimedia module to facilitate the interaction between the multimedia component 608 and the processing component 602.

The multimedia component 608 is configured to store various types of data to support operations in the terminal 600. Examples of these data include instructions for any application or method operated on the terminal 600, contact data, phone book data, messages, pictures, videos, and the like. The multimedia component 608 can be implemented by any type of volatile or non-volatile storage device or the combination thereof, such as static random access memory (SRAM), electrically erasable programmable read-only memory (EEPROM), erasable Programmable read-only memory (EPROM), programmable read-only memory (PROM), read-only memory (ROM), magnetic memory, flash memory, magnetic disk or optical disk.

The power component 606 provides power to various components of the terminal 600. The power component 606 may include a power management system, one or more power supplies, and other components associated with generating, managing, and distributing power for the terminal 600.

The multimedia component 608 includes a screen that provides an output interface between the terminal 600 and the user. In some embodiments, the screen may include a liquid crystal display (LCD) and a touch panel (TP). If the screen includes a touch panel, the screen may be implemented as a touch screen to receive input signals from the user. The touch panel includes one or more touch sensors to sense touching, sliding, and gestures on the touch panel. The touch sensor may be used to not only sense the boundary of the touching or sliding action, but also detect the duration and pressure related to the touching or sliding operation. In some embodiments, the multimedia component 608 includes a front camera and/or a rear camera. When the terminal 600 is in an operation mode, such as a shooting mode or a video mode, the front camera and/or the rear camera can receive external multimedia data. Each front camera and rear camera can be a fixed optical lens system or have focal length and optical zoom capabilities.

The audio component 610 is configured to output and/or input audio signals. For example, the audio component 610 includes a microphone (MIC), and when the terminal 600 is in an operation mode, such as a call mode, a recording mode, and a voice recognition mode, the microphone is configured to receive external audio signals. The received audio signal can be further stored in the multimedia component 608 or sent via the communication component 616. In some embodiments, the audio component 610 further includes a speaker for outputting audio signals.

The I/O interface 612 provides an interface between the processing component 602 and a peripheral interface module. The peripheral interface module may be a keyboard, a click wheel, a button, and the like. These buttons may include but are not limited to: home button, volume button, start button, and lock button.

The sensor component 614 includes one or more sensors for providing the terminal 600 with various status assessments. For example, the sensor component 614 can detect the on/off state of the terminal 600 and the relative positioning of components, such as the display and keypad of the terminal 600. The sensor component 614 can also detect position change of the terminal 600 or position change of a component of the terminal 600, presence or absence of a contacting between the user and the terminal 600, orientation or acceleration/deceleration of the terminal 600, and temperature change of the terminal 600. The sensor component 614 may include a proximity sensor configured to detect presence of nearby objects when there is no physical contacting. The sensor component 614 may also include a light sensor, such as a CMOS or CCD image sensor, for use in imaging application. In some embodiments, the sensor component 614 may also include an acceleration sensor, a gyroscope sensor, a magnetic sensor, a pressure sensor or a temperature sensor.

The communication component 616 is configured to facilitate wired or wireless communication between the terminal 600 and other devices. The terminal 600 can access a wireless network based on a communication standard, such as WiFi, an operator network (such as 2G, 3G, 4G, or 5G), or a combination thereof. In an exemplary embodiment, the communication component 616 receives a broadcast signal or broadcast related information from an external broadcast management system via a broadcast channel. In an exemplary embodiment, the communication component 616 further includes a near field communication (NFC) module to facilitate short-range communication. In an exemplary embodiment, the terminal 600 can be implemented by one or more application specific integrated circuits (ASIC), digital signal processors (DSP), digital signal processing devices (DSPD), programmable logic devices (PLD), field programmable Implemented by a gate array (FPGA), controller, microcontroller, microprocessor, or other electronic components, and used to perform the above method for playing audio applied to the terminal.

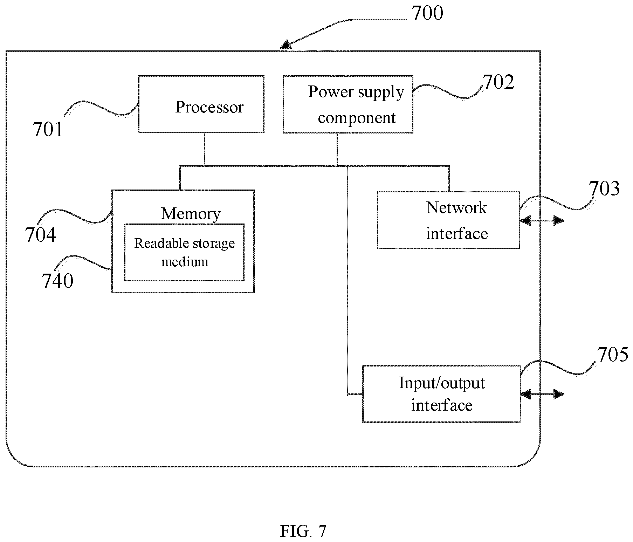

Referring to FIG. 7, FIG. 7 is a structural block diagram of a server according to embodiments of the disclosure. The server 700 may include a processor 701, a power supply component 702, a network interface 703, a memory 704, and an input/output interface 705. The memory 704 is provided with a non-transitory computer-readable storage medium 7041, and the readable storage medium 7041 stores instructions for executing the above method for establishing an association relationship. The memory 704 can communicate with the processor 701. When the instructions in the storage medium 740 are executed by the processor 701, the server 700 can perform the operations performed by the method for playing audio applied to the server. The network interface 703 can connect the server 700 to the network, and the power supply component 702 can perform power management of the server 700.

In some embodiments, the readable storage medium 740 may be a non-transitory computer readable storage medium. For example, the non-transitory computer readable storage medium 740 may be ROM, random access memory (RAM), CD-ROM, magnetic tape, floppy disks and optical data storage devices, and the like.

Those skilled in the art will easily think of other embodiments of the disclosure after considering the description and practicing the embodiments disclosed herein. This application is intended to cover any variations, uses, or adaptive changes of the disclosure. These variations, uses, or adaptive changes follow the general principles of the disclosure and include common knowledge or conventional technical means in the technical field not disclosed in the disclosure. The description and the embodiments are only regarded as exemplary, and the true scope and spirit of the disclosure are pointed out by the attached claims.

It should be understood that the disclosure is not limited to the precise structure that has been described above and shown in the drawings, and various modifications and changes can be made without departing from the scope thereof. The scope of the disclosure is only defined by the appended claims.

## Claims

1. A method for playing audio, applied to a terminal, comprising:
sending (S11) a response request to a server in response to detecting a voice input;
receiving (S12) a response audio clip carrying position information sent by the server, the position information indicating a position of the response audio clip in a response audio corresponding to the response request;
synthesizing (S13), based on the position information carried by respective received response audio clips, adjacent response audio clips into a response audio packet;
playing (S14) the synthesized response audio packet.

2. The method according to claim 1, wherein said playing the synthesized response audio packet comprises:
playing the response audio packet in response to a number of the response audio clip included in the response audio packet being greater than a preset number;
playing the response audio packet in response to the number of the response audio clip included in the response audio packet being less than the preset number and a duration between current moment and end time of playing of a last response audio packet reaching a first preset duration.

3. The method according to claim 1, wherein the method further comprises:
playing the respective received response audio clips based on the position information, in response to the positions of respective received response audio clips being not adjacent and a duration between current moment and end time of playing of a last response audio packet reaching a second preset duration,; and
discarding the received response audio clip during playing the respective received response audio clips, in response to a response audio clip being received, wherein the response audio clip is located before the position of the response audio clip that has been played or is being played.

4. The method according to claim 2, further comprising:
extending the first preset duration and/or increasing the preset number in response to a duration between a receiving time and an end time being greater than a second preset duration, wherein a new response audio clip is received at the receiving time and playing of a last response audio packet is ended at the end time.

5. The method according to claim 1, wherein the method further comprises:
requesting (S21) the target audio clip from the server in response to the positions of the respective received response audio clips being not adjacent and an un-received response audio clip being a target audio clip, the target audio clip being a response audio clip carrying a keyword in the response audio; and
synthesizing (S22) the target audio clip and a response audio clip located adjacent to the target audio clip into the response audio packet and playing the response audio packet in response to the target audio clip being received.

6. The method according to claim 1, wherein said synthesizing, based on the position information carried by the respective received response audio clips, adjacent response audio clips into the response audio packet comprises:
determining a plurality of adjacent response audio clips based on the position information carried by the respective received response audio clips;
performing semantic analysis on the plurality of adjacent response audio clips, and synthesizing the plurality of adjacent response audio clips into the response audio packet in response to the plurality of adjacent response audio clips constituting a short sentence.

7. The method according to any one of claims 1 to 6, further comprises:
sending a persistent connection request to the server to indicate that the terminal is ready to receive the response audio clip;
receiving a persistent connection response sent by the server to establish a persistent connection with the server; and
receiving, through the persistent connection, the response audio clip carrying the position information sent by the server.

8. A method for playing audio, applied to a server, the method comprising:
receiving (S31) a response request sent by a terminal;
obtaining (S32), based on the response request, a plurality of response audio data; and
sending (S33) the response audio clip to the terminal until finishing sending the plurality of response audio data, in response to at least one piece of response audio data of the plurality of response audio data being synthesized into a response audio clip.

9. The method according to claim 8, wherein the method further comprises:
receiving a request for a target audio clip sent by the terminal, the target audio clip being a response audio clip carrying a response keyword in the response audio; and
sending the target audio clip to the terminal, causing the terminal to synthesize the target audio clip and a response audio clip adjacent to the target audio clip into a response audio packet, and playing the response audio packet.

10. The method according to claim 8, wherein, the method further comprises:
receiving a persistent connection request sent by the terminal, the persistent connection request indicating that the terminal is ready to receive the response audio clip;
establishing, in response to the persistent connection request sent by the terminal, a persistent connection with the terminal; and
said sending the response audio clip to the terminal comprises:
sending, through the persistent connection, the response audio clip to the terminal.

11. A device (400) for playing audio, configured to be applied to a terminal, wherein the device (400) comprises:
a first sending module (401), configured to send (S11) a response request corresponding to the voice input to a server in response to detecting the voice input;
a receiving module (402), configured to receive (S12) a response audio clip carrying position information sent by the server, the position information indicating a position of the response audio clip in a response audio corresponding to the response request;
a synthesis module (403), configured to synthesize (S13), based on the position information carried by respective received response audio clips, adjacent response audio clips into a response audio packet;
a first playing module (404), configured to play (S14) the synthesized response audio packet, until finishing playing the response audio.

12. The device according to claim 11, wherein the first playing module further comprises:
a first playing sub-module, configured to play the response audio packet in response to a number of the response audio clip included in the response audio packet being greater than a preset number;
a second playing sub-module, configured to play the response audio packet in response to the number of the response audio clip included in the response audio packet being less than the preset number, and a duration between current moment and end time of playing of a last response audio packet reaching a first preset duration.

13. The device according to claim 11, wherein the device further comprises:
a second play module, configured to play the respective received response audio clips based on the position information, in response to the positions of respective received response audio clips being not adjacent and a duration between current moment and end time of playing of a last response audio packet reaching a second preset duration,;
a clearing module, configured to discard the received response audio clip during playing the respective received response audio clips, in response to a response audio clip being received, wherein the response audio clip is located before a response audio clip that has been played or is being played.

14. The device according to claim 12, wherein the device further comprises:
an adjustment module, configured to extend the first preset duration and/or increase the preset number in response to a duration between a receiving time and an end time being greater than a second preset duration, wherein a new response audio clip is received at the receiving time and playing of a last response audio packet is ended at the end time.

15. A non-transitory computer-readable storage medium (640) in which instructions, when executed by a processor (620) of a terminal (600), cause the terminal (600) to execute a method recited in any one according to claims 1 to 7.
